# DEMANDE DE BREVET EUROPEEN

(11) **EP 0 688 050 A1**
(43) Date de publication de la demande: **20.12.1995**
(21) Numéro de dépôt: 95201547.7
(22) Date de dépôt: 12.06.1995
(51) Int. Cl.: H01L 23/498, G06K 19/077

(54) **Procédé d'assemblage de carte à circuit intégré et carte ainsi obtenue**

(30) Priorité: 15.06.1994 FR 9407307
(71) Demandeur: PHILIPS CARTES ET SYSTEMES, 75013 Paris (FR); Philips Electronics N.V., 5621 BA Eindhoven (NL)
(72) Inventeur: Launay, François, F-75008 Paris (FR); Venambre, Jacques, F-75008 Paris (FR)
(74) Mandataire: Pyronnet, Jacques

(57) **Abrégé**

Le support de carte est muni d'un logement (5) destiné à recevoir un circuit intégré ou CI (4) et dont le fond (7) est muni de plages métalliques de contact internes ou PMCI (9), reliées électriquement à des plages métalliques de contact externes ou PMCE (2). Selon l'invention, les PMCI (9) étant reliées, par des métallisations (8) sur les parois (6) du logement (5), aux PMCE (2) disposées sur la face (3) qui comporte le logement (5), l'établissement des connexions électriques entre les PMCI (9) et les plages métalliques du CI (4) consiste en un montage flip-chip du CI par collage au moyen d'une colle à conduction électrique anisotrope (36), sous certaines conditions de température et de pression, après quoi la colle est polymérisée.

Application aux cartes à puce électroniques.

## Description

La présente invention concerne un procédé d'assemblage de carte électronique comportant un support de carte en matière plastique muni d'un logement destiné à recevoir un circuit intégré et dont le fond est muni de plages métalliques de contact internes à connecter aux plages métalliques de contact du circuit intégré. Ces plages métalliques de contact internes sont reliées à des plages métalliques de contact externes qui sont disposées soit sur la face du support qui comporte ledit logement, au moyen de pistes électriquement conductrices qui parcourent les parois du logement, soit sur l'autre face du support, opposée à celle qui comporte ledit logement, par des traversées métallisées à travers le fond du logement.

L'invention concerne aussi la carte électronique obtenue par ce procédé.

Le circuit intégré (ou puce), inséré dans le logement du support peut être une mémoire électronique, ou un microprocesseur, de surface plus grande que la simple mémoire.

Les procédés couramment employés pour la réalisation de cartes à puce électroniques utilisent un circuit imprimé déposé sur un film support, généralement en verre époxy, en polyimide ou en polyester, comme décrit par exemple dans le brevet européen EP 0 201 952 B1 au nom de la demanderesse (PHF 85/533). Il est aussi connu d'utiliser une grille surmoulée. Le film support ou la grille portent sur l'une des faces les plages métalliques de contact externe de la carte : l'autre face sert de support à la puce électronique qui est reliée électriquement aux contacts externes, à travers le film, ou la grille. Le matériau du film support et le matériau utilisé pour le surmoulage des grilles sont isolants afin d'isoler électriquement les contacts externes et les connexions internes de la puce électronique.

L'assemblage de la carte à puce consiste alors à :
- coller le circuit intégré (la puce) sur la face interne du film ou de la grille,
- réaliser les connexions électriques reliant les contacts de la puce aux plages métalliques de contacts externes (au moyen de fils conducteurs),
- protéger la puce et les connexions au moyen d'une résine de protection,
- découper le module électronique ainsi formé pour le détacher du film support ou de la grille,
- insérer et coller le module dans un support de carte en matière plastique (généralement du PVC, de l'ABS ou du polycarbonate) dans laquelle a été préalablement réalisé un logement (cavité) pour recevoir ledit module par son côté qui supporte le circuit intégré (la puce). Ce logement peut être réalisé par moulage par injection ou par lamage.

Avec ces procédés, l'opération de protection de la puce électronique et des connexions est souvent délicate car l'épaisseur de cette protection doit être parfaitement contrôlée pour permettre l'insertion dans la cavité du support de carte qui ne dépasse pas 650 µm de profondeur.

L'insertion du module électronique dans la carte est également délicate et exige des tolérances de planéité et de positionnement latéral très serrées pour éviter les problèmes d'utilisation dans les lecteurs ou de logement du module dans la cavité.

Par ailleurs, le collage du module électronique doit être très efficace pour satisfaire les tests de torsion et de flexion imposés.

Enfin, ces procédés nécessitent l'emploi de film ou de grilles qui entrent pour une part importante dans le coût final du produit.

Pour pallier ces inconvénients il est connu, selon un nouveau procédé assez récent, de fixer les plages métalliques de contact internes et externes directement sur la carte, comme indiqué au premier paragraphe, ce qui supprime l'étape intermédiaire d'un module électronique porteur du circuit intégré, rapporté par collage sur le support de carte, dans le logement. Des demandes de brevet WO 92/13319 et WO 92/13320 notamment, il est connu d'appliquer des plages métalliques de contact internes et externes qui communiquent par des traversées métallisées, de part et d'autre du fond du logement, en une même opération, puis de placer le circuit intégré au fond du logement et de le connecter aux plages métalliques de contact internes. Entre autres procédés possibles pour la connexion du circuit intégré, il est prévu un montage flip-chip classique, selon lequel des surépaisseurs métalliques réalisées sur les contacts du circuit intégré, sont solidarisées par des moyens de liaison électrique et mécanique appliqués ponctuellement tels que la brasure ou le collage à l'aide d'une colle conductrice, à des surépaisseurs métalliques correspondantes sur les plages métalliques de contact internes. Cette technique connue pose le problème technique de devoir effectuer une opération supplémentaire de reprise délicate du circuit intégré après sa fabrication, pour la réalisation sur ses contacts des surépaisseurs généralement réalisées en or ou en cuivre recouvert d'étain.

Un but de la présente invention est de réduire le nombre d'étapes de procédé pour l'assemblage d'une carte à circuit intégré.

Un autre but est de pouvoir utiliser, en vue de son montage dans une carte, un circuit intégré tel qu'il est habituellement commercialisé, c'est-à-dire dont les contacts ne nécessitent pas de surépaisseurs métalliques rapportées.

Ces buts sont atteints et les inconvénients de l'art antérieur sont atténués grâce au fait que le procédé d'assemblage défini au premier paragraphe est remarquable en ce que, les plages métalliques dudit circuit intégré étant démunies de surépaisseurs, l'établissement des connexions électriques entre lesdites plages métalliques de contact interne et les plages métalliques dudit circuit intégré consiste en un procédé de montage flip-chip particulier du circuit intégré, lesdites connexions étant réalisées par collage, associé à une pression, au moyen d'une colle à conduction électrique anisotrope, préalablement déposée au fond dudit logement, après quoi ladite colle à conduction électrique anisotrope est polymérisée.

Lors du collage, la colle à conduction électrique anisotrope s'étend contre la face active du circuit intégré qui porte les contacts, étant entendu que, pour un tel montage, la masse du circuit intégré est ramenée sur cette face et constitue un contact parmi d'autres. Cette colle se présente soit sous la forme d'un film préformé, d'épaisseur calibrée, soit sous forme d'une pâte et peut être déposée, préalablement au collage, soit sur la face du circuit porteuse des contacts, soit, de préférence, au fond du logement, sur les plages métalliques de contact internes à l'endroit où les extrémités de ces dernières forment une configuration symétrique (par rapport à un plan) de celle des contacts du circuit intégré. On notera que l'utilisation de colle anisotrope est déjà connue en soi pour le montage de composants sur circuit imprimé et notamment pour la connexion d'une carte imprimée souple à du verre muni de pistes conductrices dans des afficheurs à cristaux liquides.

Un mode de réalisation préféré du procédé d'assemblage selon l'invention est remarquable en ce que ladite colle à conduction électrique anisotrope est prépolymérisée pendant le dépôt flip-chip du composant dans le logement, puis, après mise en oeuvre de ce procédé, ledit logement est comblé avec une résine de protection compatible avec la colle utilisée pour le montage flip-chip, après quoi est effectuée la polymérisation simultanée de ladite résine et de ladite colle.

Une telle façon d'opérer permet d'économiser une étape, lors de l'assemblage, étant donné que deux opérations de polymérisation successives de la colle puis de la résine de protection ne sont dès lors plus nécessaires.

Pour s'affranchir totalement de risques de courts-circuits entre plages métalliques de contact internes ou entre l'une de ces plages et une partie de bord du circuit intégré qui serait démunie de sa couche de passivation, il est avantageux d'utiliser, pour l'assemblage de la carte, un support de carte réalisé, avec son logement, selon une technique de moulage par injection et comportant des surépaisseurs, d'ailleurs réalisables par moulage, au fond du logement, aux emplacements prévus pour lesdites plages métalliques de contact internes.

Un problème technique peut encore se poser lors de l'interconnexion entre contacts du circuit intégré et contacts de la carte : comme le circuit intégré est très petit, de l'ordre de 1 à quelques mm², une grande précision de positionnement du circuit intégré est nécessaire, si l'on veut éviter des distances très faibles entre plages métalliques de contact internes. D'autre part, un positionnement précis n'est pas facilité par la couche de colle anisotrope qui masque l'une des configurations de contacts disposés en regard.

Pour faciliter le positionnement du circuit intégré dans le logement, on peut prévoir que le support de carte comporte des surépaisseurs-guides prévues au fond dudit logement permettant un positionnement précis des contacts à connecter dudit circuit intégré, lors du montage flip-chip de ce dernier, par guidage en place de ses bords.

La description qui suit en regard des dessins annexés, le tout donné à titre d'exemple non limitatif, fera bien comprendre comment l'invention peut être réalisée.

La figure 1 représente, vue en plan à grande échelle, avec arrachement, une carte à circuit intégré assemblée par le procédé selon l'invention.

La figure 2 est la section II-II agrandie, avec arrachement, de la figure 1.

La figure 3 est la section III-III agrandie, avec arrachement, de la figure 2.

La figure 4 illustre, selon le même mode de représentation qu'à la figure 2, une variante du mode de réalisation des figures 1 à 3.

La figure 5 est une vue en plan du logement, très agrandie, selon le mode de réalisation des figures 1 à 3, où le support de carte comporte des surépaisseurs-guides.

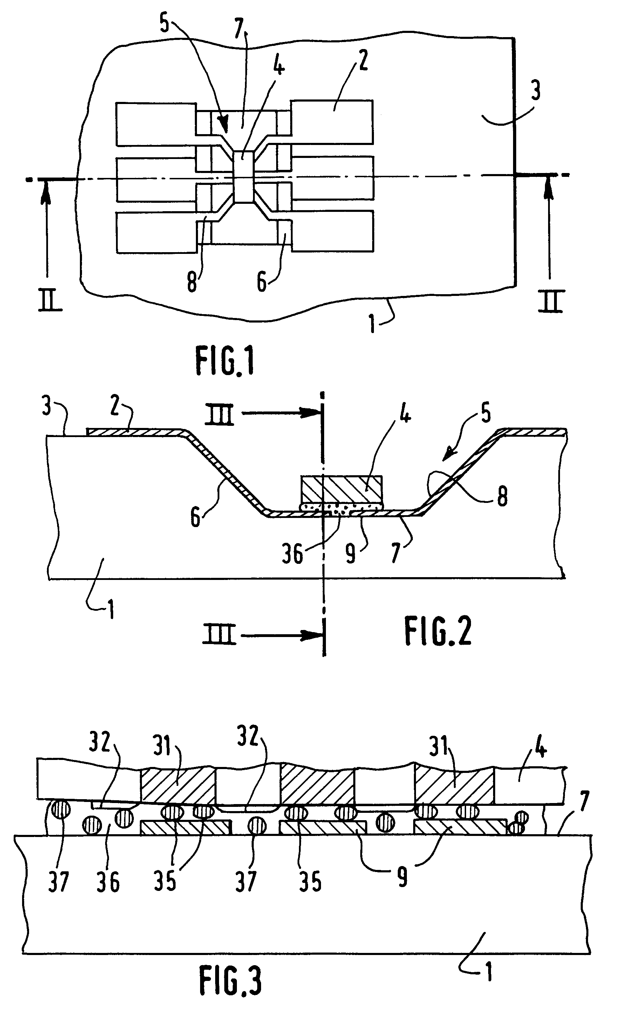

Aux figures 1 et 2 sont représentées les parties actives d'une carte à circuit intégré, où se trouvent les plages métalliques de contact externes destinées à être reliées électriquement avec les palpeurs d'un lecteur de carte. Le support de carte 1 comporte ces plages 2, de dimensions et de positionnement normalisés, sur une face 3 (dite supérieure) de la carte. Les plages métalliques sont, au moins pour certaines, reliées électriquement aux contacts d'un circuit intégré (ou puce) 4 qui est compris dans l'épaisseur du corps, ou support de carte 1.

Pour la mise en oeuvre du procédé selon l'invention, le support 1 comporte un logement 5 avec des parois latérales par exemple inclinées telles que 6 et dont le fond 7 est destiné à recevoir la puce de circuit intégré 4, et des pistes conductrices 8 (dites aussi lignes de métallisation) qui forment une continuité avec les plages 2, s'étendent de la face 3 du corps de carte, jusqu'au fond 7 du logement où se trouve leur extrémité libre 9 en passant sur les parois latérales du logement 1 qu'elles traversent (parcourent). Le logement 5 doit avoir une profondeur inférieure à 650 µm afin de laisser une épaisseur de plastique suffisante en fond de carte pour éviter une cassure dudit fond de carte et protéger la puce électronique. Divers procédés peuvent être utilisés, de façon connue en soi, pour solidariser les pistes 8, essentiellement en cuivre, au support 1 qui est réalisé, avec son logement 5, de préférence par moulage par injection d'une matière thermoplastique telle que de l'ABS, ou du polycarbonate. Certains de ces procédés sont décrits plus loin.

Pour la réalisation des connexions électriques reliant les contacts du circuit intégré 4 mis en place dans le logement aux extrémités 9 des pistes au fond du logement, qui constituent des plages métalliques de contact internes, on utilise, selon l'invention, un procédé particulier de montage flip-chip représenté en détail à la figure 3. On notera, sur cette figure, que les contacts 31 de la puce de circuit intégré ne comportent pas de surépaisseurs. Quant aux plages métalliques de contact internes 9, sur le fond 7 du logement 5, elles sont représentées aussi sans surépaisseurs, mais elles pourraient comporter, de préférence, de telles surépaisseurs et, de préférence aussi, de forme cylindrique, comme décrit plus loin.

Pour le montage flip-chip représenté, est utilisée une colle particulière dite à conduction électrique anisotrope, déjà utilisée notamment pour le montage en surface de composants passifs. Ce type de colle contient des particules conductrices en faible concentration. Ces particules, élastiquement déformables, dont le diamètre est de l'ordre de 10 à 20 µm, permettent une conduction électrique lorsqu'elles sont pressées entre deux contacts, la colle restant isolante aux endroits où il n'y a pas de contacts. Des métallisations carrées de 100 µm de côté avec des espacements de 100 µm sont compatibles avec l'utilisation de ces colles en ce qui concerne l'aspect conduction (densité de particules se trouvant sur la métallisation au moment du collage -il faut en effet compter plusieurs particules, plutôt qu'une seule, qui serait théoriquement suffisante, pour l'établissement d'un bon contact-) et ne présentent pas de risque de court-circuit entre pistes conductrices. Ces colles sont actuellement disponibles sous forme de film ou sous forme de pâtes. Fabriquent des films de colle anisotrope notamment la société américaine 3M, la société japonaise HITACHI tel le film référencé AC8O21X, la société japonaise SONY tel le film 93C5X3O, et des pâtes, notamment la société américaine AIT telle la pâte ZME 8155, la société allemende LCD MIKROELECTRONIC telle la pâte RO22/23, ou la société américaine ZYMET qui fabrique une pâte polymérisable aux UV. Pour la mise en oeuvre de l'invention, la colle anisotrope sous forme de pâte est préférée à celle sous forme de film. On notera que, pour l'utilisation de cette technique de contact, un compromis doit être trouvé entre l'établissement d'une bonne conduction électrique au niveau de chaque contact de la puce et l'absence de courts-circuits dûs à des agglomérats de particules entre pistes. A contraintes de dimensionnement des contacts égales, ce compromis est d'autant plus facile à réaliser dans la mesure où il est possible d'augmenter la concentration en particules tout en diminuant leur taille. Mais pour que cette diminution de taille soit possible, il faut arriver à obtenir une bonne planéité de l'ensemble des extrémités des pistes sur le fond 7 du logement (celle des contacts du circuit intégré étant par ailleurs acquise).

Le détail du procédé d'assemblage du circuit intégré 4 sur le support de carte 1 est le suivant, après que les deux éléments précités ont été soigneusement nettoyés.

La pellicule de colle, sous forme de film ou de pâte, référencée 36 sur les figures 2 et 3, est placée sur l'une des configurations de contacts, sur le circuit intégré ou bien, de préférence, sur le fond 7 du logement 5. Après mise en regard (alignement) des contacts des deux substrats, une certaine chaleur et une certaine pression sont appliquées simultanément. La chaleur est de l'ordre de 100 à 200°C, la pression de l'ordre de 200 à 400 N/cm² et la durée d'application de l'ordre de 10 à 30 s. La colle est ensuite polymérisée, par action thermique ou par rayonnement UV, suivant le type de colle utilisé. Après ces traitements, les particules pincées entre les contacts sont élastiquement déformées, ce qui résulte en une force de contact additionnelle. Ces particules peuvent être en fibre de carbone, des particules métalliques, ou des sphères en matière plastique enrobées de métal, leur diamètre moyen étant de l'ordre de 10 µm.

Le résultat obtenu par le procédé précité est représenté à la figure 3. On a représenté d'une part le circuit intégré 4, avec ses contacts 31 et une couche de passivation superficielle entre contacts, 32, d'autre part le fond 7 du logement dans le support de carte 1, muni des extrémités de pistes 9 qui ne comportent pas de surépaisseurs en l'occurrence. Par collage, accompagné d'une certaine pression, des particules conductrices telles que 35 ont été emprisonnées dans la colle 36 puis comprimées entre les paires de contacts 9 et 31. D'autres particules, telles que 37 sont situées en dehors des contacts et ne participent à aucune conduction électrique.

Il existe trois types de colles anisotropes : celles sensibles à la pression, les colles thermoplastiques et les colles thermodurcissables. Les colles préférées ici sont les colles thermoplastiques qui ont un temps de stockage assez long et pour lesquelles il ne se pose pas de problème de fortes montées en température lors de l'utilisation ultérieure de la carte. Il est aussi possible d'utiliser un mélange de colles thermodurcissable et thermoplastique.

En variante au procédé de collage indiqué plus haut, il est possible d'opérer une prépolymérisation de la colle, après qu'elle a été déposée sur l'une des configurations de contacts et avant l'alignement des contacts des deux substrats.

Les procédés préférés pour l'application des pistes conductrices 8 sur le support 1 sur une surface non plane, dite 3D, sont :
- l'emboutissage à chaud d'une configuration de pistes collables, dit Hot Foil Embossing en anglais,
- le procédé de tampographie, suivi d'une métallisation par autocatalyse,
- la réalisation de pistes par lithogravure obtenue à partir d'hologrammes laser.

Parmi ces trois procédés les deux premiers sont relativement bien connus et éprouvés, assez économiques, mais ne permettent pas d'obtenir une grande résolution pour la réalisation des pistes. Lorsqu'une grande résolution est requise, le troisième procédé, plus précis, peut être utilisé.

Les techniques de tampographie et de lithogravure sont compatibles avec la création de surépaisseurs aux extrémités 9 des pistes conductrices, réalisées au fond du logement lors du moulage par injection du support 1.

Concernant le procédé d' emboutissage (ou encore d'estampage) à chaud, on peut citer à titre d'exemple le contenu du brevet EP 0 063 347. Avec un cycle thermique d'une durée de l'ordre de 2 s, une configuration de pistes métalliques de 12 à 70 µm d'épaisseur peut être appliquée contre le support de carte, à l'endroit du logement 5 dont la forme est conçue à cet effet, c'est-à-dire avec parois inclinées de préférence, la pression d'application étant de l'ordre de 80 N/mm² et la température de l'ordre de 200°C. A cet effet, les feuilles d'estampage à chaud qui comportent les configurations de pistes sont constituées d'une ou plusieurs couches de colle réactivable à chaud (généralement à base de phénols) ayant une épaisseur de 1 à 4 µm, une couche de cuivre, assez ductile, d'épaisseur comprise entre 12 et 35 µm, et éventuellement une couche d'étain ou de nickel de quelques µm d'épaisseur. La partie de la feuille qui n'est pas estampée peut ensuite être otée à partir d'une station d'enroulement avec du ruban adhésif.

Par le procédé de tampographie, avec une durée de cycle de 2 s, une laque contenant du palladium peut être imprimée contre le support de carte 1, contre les parois et le fond du logement 5 et autour de ce dernier sur la face 3, selon le dessin requis pour la configuration des pistes métalliques à créer à cet endroit. La qualité de l'impression est bonne, puisqu'il est ainsi possible d'obtenir une précision de l'ordre de 50 µm pour la largeur des pistes conductrices aussi bien que pour la distance de séparation entre pistes.

La laque contenant du Pd, qui constitue un catalyseur et qui est déposée aux endroits adéquats sur le support 1, est ensuite chauffée à 100°C. Puis une métallisation (cuivre ou nickel) par autocatalyse est effectuée, cette dernière opération étant depuis longtemps connue et maîtrisée : le cuivre(nickel) ne se dépose, sur le support 1, qu'aux endroits où du catalyseur est présent. L'épaisseur de cuivre déposé est comprise entre 1 et 10 µm. Le principal avantage de ce procédé électrochimique de métallisation est que plusieurs milliers à plusieurs dizaines de milliers de cartes peuvent être traitées en même temps, plongées ensemble dans un même bain, en l'espace de quelques heures.

Lorsqu'une plus grande précision est nécessaire, pour le dessin des pistes conductrices dans le logement 5, il est possible d'utiliser un procédé de photolithographie, plus coûteux que les précédents. Cette technique est la transposition de la technique de photolithographie classique, pour la métallisation de surfaces planes, à la métallisation de surfaces gauches, en l'occurrence les parois et le fond du logement 5 et ses abords immédiats sur la face 3 du support. Pour cela, une technique de mise au point par masques 3D ou hologramme laser est possible, qui consiste à réaliser l'image des pistes en 3D sur une surface qui coïncide avec celle du logement, ce qui permet d'obtenir la polymérisation d'un vernis seulement aux endroits voulus sur la surface du logement.

Par exemple, un procédé semi additif peut être utilisé pour la réalisation des pistes. Ce procédé, actuellement utilisé dans les principaux pays développés, consiste à effectuer un traitement du support plastique pour améliorer l'adhérence d'un dépôt métallique, du cuivre de préférence, sur lequel on fait ensuite croître des couches de contacts électriques en utilisant un masque de photorésist. Après exposition, le masque et les couches autour des contacts sont éliminés. Ce procédé permet donc des métallisations sur des supports non plans en utilisant des masques 3D ou des techniques au laser (génération d'hologrammes), et procure une résolution de l'ordre de 50 µm. Au moyen des différents procédés de métallisation précités, les contacts électriques ne sont plus supportés par un film ou une grille, comme dans l'art antérieur, mais par le support de carte lui-même. De plus, les opérations de traversée d'un matériau isolant, pour l'établissement des contacts ne sont plus indispensables.

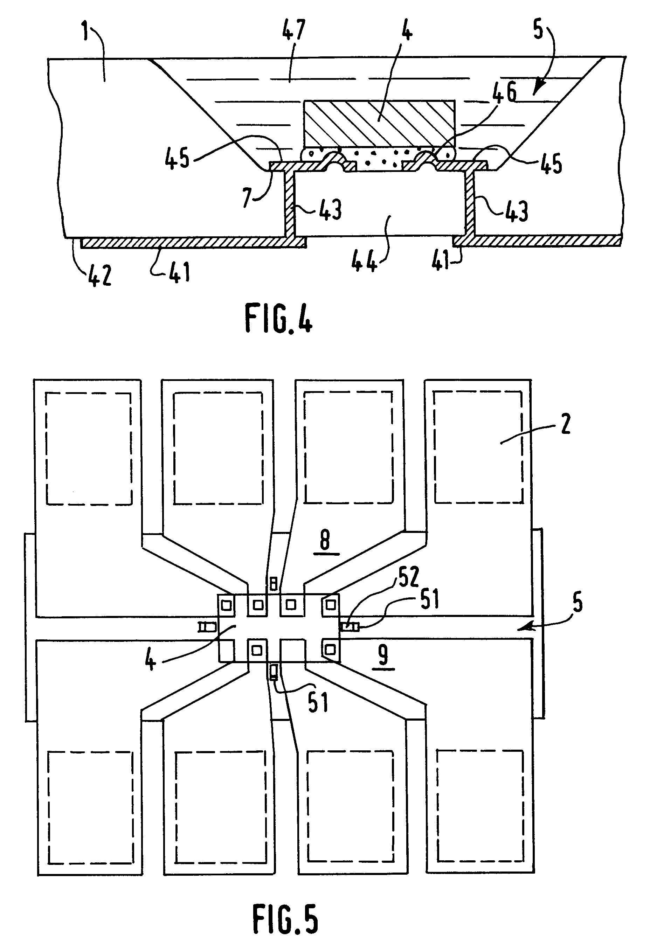

Pour le mode de réalisation représenté à la figure 4, les plages métalliques de contact externes 41 ont été appliquées de l'autre côté de la carte, par rapport au premier mode de réalisation des figures 1 à 3, c'est-à-dire sur la face 42 qui ne comporte pas le logement, et des traversées métalliques 43 à travers le fond du logement, 44, les relient aux plages métalliques de contact internes 45 dont la disposition est la même que pour le premier mode de réalisation. Cette structure de contacts liés au support de carte est connue des demandes de brevets déjà citées WO 92/13319 et WO 92/13320. Les métallisations 43, 41 et 45 peuvent être réalisées par tout moyen connu dans la technique des circuits imprimés multicouches et il est aussi possible d'utiliser, pour la réalisation des plages métalliques, la technique de lithographie décrite ci-dessus pour la réalisation des métallisations 2, 8 et 9.

Le procédé d'assemblage proprement dit, c'est-à-dire le collage à contact électrique du circuit intégré 4 contre le fond 7 du logement 5 est le même que celui décrit pour le premier mode de réalisation. Cependant, on a représenté en variante, à la figure 4, des surépaisseurs 46 sur les plages métalliques de contact externes, qui visent à faciliter l'établissement des contacts électriques. Ces surépaisseurs sont réalisées de préférence lors du moulage par injection du support de carte 1 réalisé en ABS ou polycarbonate : leur forme peut avoir l'aspect d'une calotte sphérique, comme représenté en 46 figure 4 ou, de préférence, être cylindrique, et leur hauteur de l'ordre de une à quelques dizaines de microns. Il est recommandé de choisir la hauteur des surépaisseurs inférieure de quelques microns à l'épaisseur de la colle anisotrope utilisée pour la fixation du circuit intégré. La métallisation des surépaisseurs sur les plages métalliques de contact externes peut être effectuée en même temps que les autres métallisations du fond du logement.

Il est aussi représenté, à la figure 4, le résultat d'une opération supplémentaire à la fixation du circuit intégré.

Après montage et collage de la puce, une opération de remplissage du logement ou cavité 5 peut être réalisée par un procédé simple dit de potting en anglais et qui consiste en le dépôt d'une goutte de résine 47 dans la cavité 5. Afin d'obtenir une surface externe plane, on utilise de préférence des résines à très faible viscosité, telle par exemple la résine référencée 931-1 de la société américaine ABLESTICK. Cette résine doit posséder une haute pureté ionique et présenter une bonne résistance à l'absorption d'eau afin de protéger la puce électronique de façon efficace au cours des tests climatiques. Après application dans la cavité, la résine est polymérisée, ce qui constitue une dernière étape avantageuse de finition pour le procédé d'assemblage selon l'invention, laquelle est d'ailleurs recommandée pour le premier mode de réalisation, quoique non représentée à la figure 2.

La simplicité de cette opération de potting permet l'utilisation de système remplissant plusieurs cavités à la fois et donc l'obtention de capacités de production élevées par équipement. La résine utilisée est de préférence une résine de haute pureté ionique offrant une bonne résistance à l'absorption d'humidité et protégeant efficacement la puce de circuit intégré lors des flexions et des torsions de la carte.

Il faut noter que l'emploi d'une colle pour le collage de la puce et d'une résine de protection compatibles et possédant le même mode de polymérisation (thermique ou UV) permet de réaliser les opérations de collage de la puce et le remplissage de la cavité avec le même équipement. La séquence des opérations est alors la suivante :
- collage de la puce,
- remplissage de la cavité à l'aide d'un dispenseur de résine monté sur l'amenage de l'équipement de collage,
- polymérisation simultanée de la colle du circuit intégré et de la résine d'enrobage. Dans cette éventualité, il est recommandé toutefois de prépolymériser la colle anisotrope avant son application sur le fond du logement. Dans ce cas, un seul équipement permet de réaliser l'intégralité du montage.

Il est décrit ci-dessus, en référence à la figure 4, des surépaisseurs 46 destinées à faciliter les contacts électriques pendant l'assemblage. Selon la même technique, de préférence celle du moulage par injection du support de carte, il est possible de réaliser des surépaisseurs-guides sur le fond 7 du logement 5, comme décrit ci-dessous en référence à la figure 5, sur laquelle les plages métalliques de contact externes et les plages métalliques de contact internes sont situées sur la même face de la carte qui comporte le logement 5 (premier mode de réalisation).

Sur cette figure 5, les bords de la carte ne sont pas représentés. Les plages métalliques de contact externes 2 sont repérées par des rectangles en trait interrompu, au nombre de 8. Lors de la fabrication du support de carte, quatre surépaisseurs-guides 51, ayant une hauteur de l'ordre de 100 µm ont été créées autour de la configuration formée ultérieurement pour les plages métalliques de contact internes lors des métallisations, de préférence en dehors des zones à métalliser. Ces surépaisseurs 51 entourent un rectangle de dimensions légèrement supérieures, de quelques microns aux dimensions maximales du circuit intégré à insérer, compte tenu des tolérances. Chaque surépaisseur comporte un plan incliné ou biseau, dirigé vers le centre du rectangle entouré. Lors de la mise en place du circuit intégré 4 au fond du logement, un léger défaut de positionnement du circuit est ainsi corrigé par glissement latéral contre 1 ou 2 biseau(x) 52. La présence des surépaisseurs-guides 51 permet, si nécessaire, de rendre les plages métalliques de contact externes 9 plus fines, ce qui augmente les distances qui les séparent et donc diminue la probabilité de courts-circuits entre plages métalliques, et autorise l'utilisation de colles à densité de particules plus élevée, ce qui favorise l'établissement de bons contacts électriques entre plages métalliques de contact internes et contacts du circuit intégré.

## Revendications

1. Procédé d'assemblage de carte électronique comportant un support de carte en matière plastique muni d'un logement destiné à recevoir un circuit intégré et dont le fond est muni de plages métalliques de contact internes reliées électriquement à des plages métalliques de contact externes, caractérisé en ce que, lesdites plages métalliques de contact internes étant reliées, par des pistes électriquement conductrices qui parcourent les parois du logement, auxdites plages métalliques de contact externes disposées sur la face du support qui comporte ledit logement et les plages métalliques dudit circuit intégré étant démunies de surépaisseurs, l'établissement des connexions électriques entre lesdites plages métalliques de contact interne et les plages métalliques dudit circuit intégré consiste en un procédé de montage flip-chip particulier du circuit intégré, lesdites connexions étant réalisées par collage, associé à une pression, au moyen d'une colle à conduction électrique anisotrope, préalablement déposée au fond dudit logement, après quoi ladite colle à conduction électrique anisotrope est polymérisée.

2. Procédé d'assemblage de carte électronique comportant un support de carte en matière plastique muni d'un logement destiné à recevoir un circuit intégré et dont le fond est muni de plages métalliques de contact internes reliées, par des traversées métallisées à travers le fond du logement, à des plages métalliques de contact externes disposées sur la face du support opposée à celle qui comporte ledit logement, caractérisé en ce que, les plages métalliques dudit circuit intégré étant démunies de surépaisseurs, l'établissement des connexions électriques entre lesdites plages métalliques de contact interne et les plages métalliques dudit circuit intégré consiste en un procédé de montage flip-chip particulier du circuit intégré, lesdites connexions étant réalisées par collage, associé à une pression, au moyen d'une colle à conduction électrique anisotrope, préalablement déposée au fond dudit logement, après quoi ladite colle à conduction électrique anisotrope est polymérisée.

3. Procédé d'assemblage selon la revendication 1 ou 2, caractérisé en ce que ladite colle à conduction électrique anisotrope est déposée au fond du logement sous forme d'un film préformé.

4. Procédé d'assemblage selon la revendication 1 ou 2, caractérisé en ce que ladite colle à conduction électrique anisotrope est déposée au fond du logement sous forme d'une pâte.

5. Procédé d'assemblage selon l'une des revendications 1 à 4, caractérisé en ce que ladite colle à conduction électrique anisotrope est prépolymérisée lors du dépôt flip-chip du composant dans le logement, puis, après mise en oeuvre de ce procédé, ledit logement est comblé avec une résine de protection compatible avec la colle utilisée pour le montage flip-chip, après quoi est effectuée la polymérisation simultanée de ladite résine et de ladite colle.

6. Procédé d'assemblage selon l'une des revendications 1 à 5 mettant en oeuvre un support de carte réalisé, avec son logement, selon une technique de moulage par injection, et comportant des surépaisseurs, au fond du logement aux emplacements prévus pour lesdites plages métalliques de contact internes.

7. Procédé d'assemblage mettant en oeuvre un support de carte réalisé, avec son logement, selon une technique de moulage par injection, selon l'une des revendications 1 à 6, selon lequel des surépaisseurs-guides prévues au fond dudit logement permettent un positionnement précis des contacts à connecter dudit circuit intégré lors du montage flip-chip de ce dernier, par guidage en place de ses bords.

8. Carte électronique à circuit intégré obtenue par le procédé selon l'une des revendications 1 à 7.
